# EUROPEAN PATENT SPECIFICATION

(11) **EP 0 321 224 B1**
(45) Date of publication and mention of the grant of the patent: **11.08.1993**
(21) Application number: 88311846.5
(22) Date of filing: 14.12.1988
(51) Int. Cl.: H04N 1/028, H01L 27/14

(54) **Image sensor**
Bildsensor
Capteur d'images

(30) Priority: 18.12.1987 JP 321688/87; 18.12.1987 JP 321689/87
(43) Date of publication of application: 21.06.1989
(73) Proprietor: SEMICONDUCTOR ENERGY LABORATORY CO., LTD., Atsugi-shi Kanagawa-ken, 243 (JP)
(72) Inventor: Fukada, Takeshi, Ebina-shi Kanagawa-ken (JP); Codama, Mitsufumi, Atsugi-shi Kanagawa-ken (JP); Sakama, Mitsunori, Hiratsuka-shi Kanagawa-ken (JP); Amachi, Nobumitsu, Atsugi-shi Kanagawa-ken (JP); Sakamoto, Naoya, Atsugi-shi Kanagawa-ken (JP); Takayama, Ichiro, Atsugi-shi Kanagawa-ken (JP)
(74) Representative: Milhench, Howard Leslie

(56) References cited:
- EP-A- 0 263 497
- PATENT ABSTRACTS OF JAPAN, vol. 10, no. 283 (E-440) 26 September 1986, & JP-A-61 101164 (SHARP) 20 May 1986

## Description

The present invention relates to image sensors and more particularly, though not exclusively, relates to contact image sensors, that is to say very small photoelectric conversion devices, which have attracted the interest of researchers as efforts have been made to decrease the sizes of facsimile machines, photocopying machines and the like.

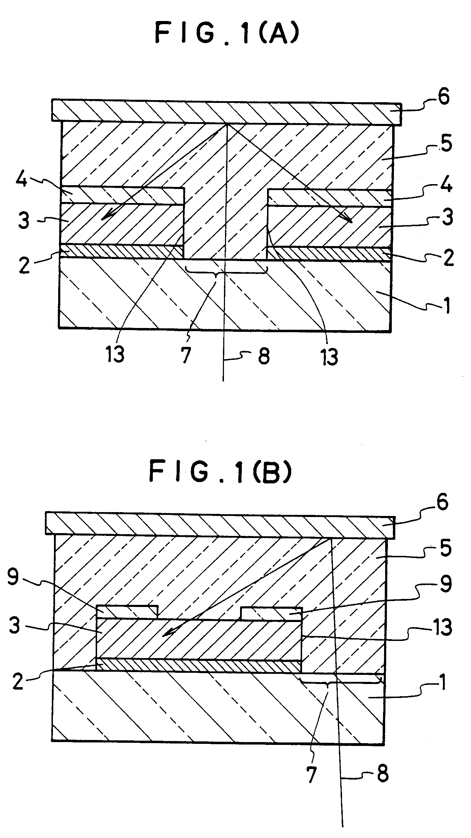

Two examples of conventional image sensors are illustrated in Figs.1(A) and 1(B).

The sensor structure of Fig.1(A) comprises a glass substrate 1, a front light blocking electrode 2, a photosensitive semiconductor film 3, a rear transparent electrode 4, and a transparent protector layer 5 which is to make direct contact with an image carrying original 6. A light window 7 is opened in the photoelectric conversion structure consisting of the electrodes 2 and 4 and the semiconductor film 3. Light rays 8 passing through the light window 7 are reflected by the original 6 and absorbed by the semiconductor film 3 for providing output signals representative of the visual information contained in the original 6.

The photoelectric conversion structure of Fig.1(A) is commonly formed by scribing the triple-layered laminae consisting of the electrodes 2 and 4 and the semiconductor film 3, and consequently there is a risk that short circuiting paths may be formed across the opposed electrodes 2 and 4 during the simultaneous scribing of the multiple layers.

The sensor illustrated in Fig.1(B) is constructed similarly to the structure of Fig.1(A) except that a metallic electrode 9 is deposited on the semiconductor film 3 after scribing of the semiconductor film 3 and the underlying light blocking electrode 2. The formation of short circuit paths between the electrodes 9 and 2 is unlikely in this case. This case, however, requires a fine patterning technique capable of fabricating comb electrode structures with adjacent conductive lines separated by several microns intervals.

Furthermore, in both of the Figs.1(A) and 1(B) devices the problem arises that noise originates as the result of light rays incident upon the side surfaces 13 of the semiconductor film, such light rays giving rise to carriers in the semiconductor irrespective of whether the original 6 is white or black and consequently reducing the quality of the copy.

It is an object of the present invention to provide an image sensor which overcomes or substantially reduces the abovementioned problems of the prior art sensors.

According to the present invention in one of its aspects there is provided an image sensor comprising a photosensitive semiconductor layer sandwiched between a transparent electrode structure on one side of the layer and a light blocking electrode structure on the other side thereof, and wherein a light window is opened through the photosensitive semiconductor layer and the light blocking electrode and one of said electrodes extends over the edges of the semiconductor layer exposed by the light window.

More particularly the present invention provides an image sensor comprising: a transparent substrate; a first electrode formed on said substrate; a photosensitive semiconductor layer formed on said first electrode; a light window provided in said first electrode and in said photosensitive semiconductor layer; a second electrode formed on said photosensitive semiconductor layer and in said light window so as to cover the side surfaces of said semiconductor layer where they are exposed by said light window; and a transparent protecting layer covering said second electrode, one of said first and second electrodes being light blocking while the other is transparent and said first and second electrodes being patterned in order to obtain photogenerating signals therebetween.

According to yet another aspect of the invention there is provided an image sensor comprising: a transparent substrate; a light blocking conductive film separated into a plurality of first electrodes by grooves; a photoelectric conversion semiconductor film formed on said light blocking conductive film; light windows opened in said semiconductor film and said light blocking conductive film; a transparent conductive film separated into a plurality of second electrodes by grooves, said second electrodes being formed also in said light windows in order to make contact with said first electrodes, whereby a plurality of photoelectric conversion elements are formed between pairs of said first and second electrodes which are opposed to each other with said semiconductor film therebetween; and a transparent protective layer formed on said transparent conductive film.

Further features of the present invention are set forth in the appended claims and, together with the abovementioned features, will become well understood from consideration of the following description given with reference to the accompanying drawings.
Figs.1(A) and 1(B) are cross sectional views showing prior art image sensors;
Fig.2 is a cross sectional view showing the structure of an exemplary image sensor in accordance with the present invention;
Fig.3 is a cross sectional view showing a modification of the embodiment illustrated in Fig.2; and
Fig.4 is a cross sectional view showing a modification of the structure shown in Fig.3.

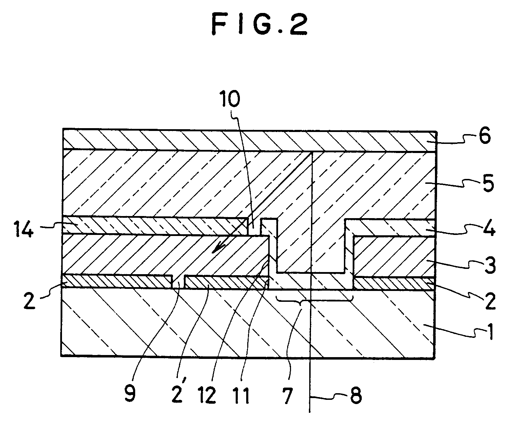

Referring now to Fig.2, a gapless type image sensor in accordance with the present invention is illustrated. The sensor comprises a glass substrate 1, a light blocking electrode 2 made of an opaque conductive material, a photosensitive amorphous silicon semiconductor film 3, a transparent electrode 4 and a protective layer 5. A light window 7 is opened in the semiconductor film 3 and the light blocking electrode 2. The transparent electrode 4 is formed so as to extend into the light window 7 and over the side surface 12 of the semiconductor film 3 where it is exposed by the window, and is electrically separated by provision of a groove 10 at a position just adjacent to the light window 7. The underlying light blocking electrode 2 is also separated by a groove 9 at a point a certain length distant from the light window 7.

The diagram of Fig.2 is illustrative only and shows only one complete sensor segment, whereas in reality a plurality of sensing elements as illustrated in the figure are formed in an array, for example in a row, in order to provide a line sensor. The deposition and patterning of an opaque conductive film, a semiconductor film and a transparent film are actually performed so that a plurality of photosensitive elements are constructed in an array, each element being composed of a light blocking electrode 2, a semiconductor film 3 and a transparent electrode 4 as illustrated in the figure. Output signals from each element can be obtained respectively between the light blocking and transparent electrodes.

The sensor of Fig.2 can be fabricated in the following manner. A chromium film is deposited to a thickness of 500 angstroms by a known sputtering technique and is then subjected to laser scribing with a KrF excimer laser (248nm) in order to define the light blocking electrode 2 which is electrically separated by the groove 9 into the right and left portions shown in the figure. The photosensitive amorphous silicon semiconductor film 3 is formed on the electrode 2 by sequentially depositing a 300 Å thick n-type amorphous silicon film, a 6000 Å thick intrinsic amorphous silicon film, and a 300 Å thick p-type amorphous silicon film in this order by a known plasma CVD process. The window 7 is opened through the electrode 2 and the semiconductor film 3 by means of the excimer laser. A 1000 Å thick ITO film is deposited by sputtering on the semiconductor film 3 and into the opening 7 so as to cover the side surfaces 12 thereof. The groove 10 which electrically separates the right and left portions of the ITO (indium tin oxide) film is formed by excimer laser scribing in the same way as the groove 9. Finally, a 10 microns thick polyimide film protective layer is formed over the structure by a known spinning technique.

In the device of Fig.2, the photosensitive region is located between the grooves 9 and 10 and, by virtue of the electrode covering the sides of the window 7, is immune to the effect of undesirable light rays, which directly enter the semiconductor film without reflecting from the original 6. Such light rays directly incident on the edge portion of the film 3 can give rise to free carriers in the semiconductor film, but these will quickly be dissipated by the electrode 4 making contact with the side surface 12 of the film 3 so that little or no noise will be induced in the signals output from the device.

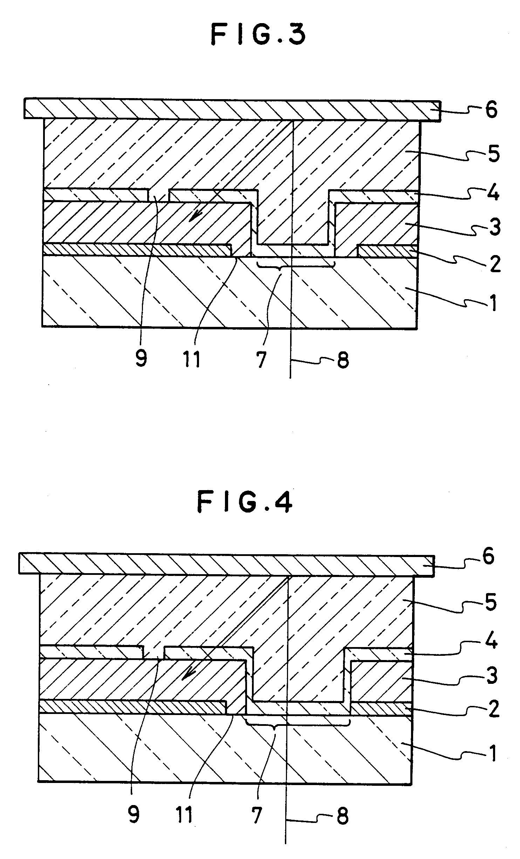

Fig.3 is a cross sectional view showing a modification of the above described embodiments. In the embodiment of Fig.3, a 120 microns wide groove is formed in the light blocking electrode 2 before the semiconductor film 3 is deposited and a 100 microns wide light window 7 is opened in the semiconductor film 3. As may be seen from the figure, the transparent electrode 4 and the light blocking electrode 2 are electrically separated by the intervening semiconductor portion between the light window 7 and the electrode 2. A groove 9 is formed at a certain distance from the window 7 so that a photosensitive region is located between the groove 9 and the window 7. In this structure, output signals are obtained between the electrodes 2 and 4.

Fig.4 is a cross sectional view showing a modification of the structure shown in Fig.3. In this structure, the right hand portion of the light blocking electrode 2 is formed in electrical contact with the transparent electrode 4 at light window 7. Output signals can be obtained between the separated portions of the electrode 2.

While several embodiments have been specifically described, it is to be appreciated that the present invention is not limited to the particular examples described and that modifications and variations can be made without departure from the scope of the invention as defined by the appended claims. For example, although the embodiments herein described are constructed with the light blocking electrodes made of chromium, composite electrodes formed of a material such as a laminate consisting of an ITO film and a Mo film for example may be used. In this case, where the constituent ITO film makes contact with the transparent electrode (made also of an ITO film) as in the embodiments of Figs. 2 and 4, the reliability of the electrical connection between the light blocking film and the transparent film is increased.

## Claims

1. An image sensor comprising a photosensitive semiconductor layer sandwiched between a transparent electrode structure on one side of the layer and a light blocking electrode structure on the other side thereof, and wherein a light window is opened through the photosensitive semiconductor layer and the light blocking electrode and one of said electrodes extends over the edges of the semiconductor layer exposed by the light window.

2. An image sensor comprising:
a transparent substrate;
a first electrode formed on said substrate;
a photosensitive semiconductor layer formed on said first electrode;
a light window provided in said first electrode and in said photosensitive semiconductor layer;
a second electrode formed on said photosensitive semiconductor layer and in said light window so as to cover the side surfaces of said semiconductor layer where they are exposed by said light window; and
a transparent protecting layer covering said second electrode, one of said first and second electrodes being light blocking while the other is transparent and said first and second electrodes being patterned in order to obtain photogenerating signals therebetween.

3. The sensor of claim 2 wherein said first electrode is light blocking and said second electrode is formed of a transparent conductive film extending to cover said light window.

4. The sensor of claim 2 or 3 wherein said light window is an opening through said first electrode and said semiconductor film.

5. The sensor of claim 4 wherein said opening in said first electrode is formed aligned with said light window.

6. The sensor of claim 4 wherein the widths of the opening in said first electrode and of said light window are equal.

7. The sensor of claim 4 wherein the width of said opening in said first electrode is larger than that of said light window.

8. The sensor of claim 7 wherein the opening in said first electrode is formed so that said first and second electrodes do not make contact with each other at said light window.

9. The sensor of claim 7 wherein the opening in said first electrode is formed so as to electrically separate said first electrode into two portions, one of which is isolated from said second electrode and the other of which makes contact with said second electrode at said opening.

10. An image sensor comprising:
a transparent substrate;
a light blocking conductive film separated into a plurality of first electrodes by grooves;
a photoelectric conversion semiconductor film formed on said light blocking conductive film;
light windows opened in said semiconductor film and said light blocking conductive film;
a transparent conductive film separated into a plurality of second electrodes by grooves, said second electrodes being formed also in said light windows in order to make contact with said first electrodes, whereby a plurality of photoelectric conversion elements are formed between pairs of said first and second electrodes which are opposed to each other with said semiconductor film therebetween; and
a transparent protective layer formed on said transparent conductive film.

## Patentansprüche

1. Bildfühler mit einer lichtempfindlichen Halbleiterschicht, die sandwichartig zwischen einer transparenten Elektrodenanordnung auf der einen Seite der Schicht und einer Lichtsperrelektrodenanordnung auf ihrer anderen Seite eingeschlossen ist, und wobei ein Lichtfenster durch die lichtempfindliche Halbleiterschicht und die Lichtsperrelektrode hindurch geöffnet ist und eine der Elektroden sich über die Kanten der Halbleiterschicht erstreckt, die durch das Lichtfenster freigelegt sind.

2. Bildfühler, mit:
einem transparenten Substrat;
einer ersten Elektrode, die am Substrat ausgebildet ist;
einer lichtempfindlichen Halbleiterschicht, die auf der ersten Elektrode ausgebildet ist;
einem Lichtfenster, das in der ersten Elektrode und in der lichtempfindlichen Halbleiterschicht vorgesehen ist;
einer zweiten Elektrode, die auf der lichtempfindlichen Halbleiterschicht und im Lichtfenster so ausgebildet ist, daß sie die Seitenflächen der Halbleiterschicht bedeckt, wo sie durch das Lichtfenster freigelegt sind; und
einer transparenten Schutzschicht, die die genannte zweite Elektrode abdeckt, wobei die genannte erste oder zweite Elektrode Licht sperrt, während die andere transparent ist, und die genannte erste und zweite Elektrode mit einem Muster versehen ist, um zwischen ihnen Lichterzeugungssignale zu erhalten.

3. Fühler nach Anspruch 2, worin die genannte erste Elektrode lichtsperrend ist und die genannte zweite Elektrode aus einer transparenten, leitfähigen Folie gebildet ist, die sich so erstreckt, daß sie das genannte Lichtfenster abdeckt.

4. Fühler nach Anspruch 2 oder 3, worin das genannte Lichtfenster eine Öffnung durch die genannte erste Elektrode und die genannten Halbleiterfolie ist.

5. Fühler nach Anspruch 4, worin die genannte Öffnung in der genannten ersten Elektrode in Ausrichtung auf das genannte Lichtfenster gebildet ist.

6. Fühler nach Anspruch 4, worin die Breiten der Öffnung in der ersten Elektrode und des Lichtfensters gleich sind.

7. Fühler nach Anspruch 4, worin die Breite der genannten Öffnung in der genannten ersten Elektrode größer ist als jene des genannten Lichtfensters.

8. Fühler nach Anspruch 7, worin die Öffnung in der genannten ersten Elektrode so geformt ist, daß die genannte erste und zweite Elektrode am genannten Lichtfenster nicht miteinander in Kontakt stehen.

9. Fühler nach Anspruch 7, worin die Öffnung in der ersten Elektrode so geformt ist, daß die genannte erste Elektrode elektrisch in zwei Abschnitte unterteilt ist, von denen einer von der genannten zweiten Elektrode isoliert ist und der andere mit der genannten zweiten Elektrode an der Öffnung in Kontakt steht.

10. Bildfühler, mit:
einem transparenten Substrat;
einer lichtsperrenden, leitfähigen Folie, die durch Nuten in eine Vielzahl erster Elektroden unterteilt ist;
einer photoelektrischen Halbleiter-Umwandlungsfolie, die auf der genannten leitfähigen Lichtsperrfolie gebildet ist;
Lichtfenstern, die in der genannten Halbleiterfolie und der genannten leitfähigen Lichtsperrfolie geöffnet sind;
einer transparenten, leitfähigen Folie, die durch Nuten in eine Vielzahl zweiter Elektroden unterteilt ist, wobei die genannten zweiten Elektroden auch in den genannten Lichtfenstern ausgebildet sind, um einen Kontakt mit den ersten Elektroden herzustellen, wodurch eine Vielzahl photoelektrischer Umwandlungselemente zwischen Paaren der genannten ersten und zweiten Elektroden gebildet sind, die einander mit der genannten Halbleiterfolie zwischeneinander gegenüberliegen; und
einer transparenten Schutzschicht, die auf der transparenten, leitfähigen Folie ausgebildet ist.

## Revendications

1. Capteur d'image comprenant une couche semi-conductrice photosensible intercalée entre une structure d'électrode transparente, d'un côté de la couche, et une structure d'électrode bloquant la lumière, de l'autre côté de ladite couche, et dans lequel une fenêtre de lumière est ouverte à travers la couche semi-conductrice photosensible et l'électrode bloquant la lumière et l'une desdites électrodes s'étend sur les bords de la couche semi-conductrice exposés par la fenêtre de lumière.

2. Capteur d'image comprenant:
un substrat transparent;
une première électrode formée sur ledit substrat;
une couche semi-conductrice photosensible formée sur ladite première électrode;
une fenêtre de lumière prévue dans ladite première électrode et dans ladite couche semi-conductrice photosensible;
une seconde électrode formée sur ladite couche semi-conductrice photosensible et dans ladite fenêtre de lumière de façon à couvrir les surfaces latérales de ladite couche semi-conductrice à l'endroit où elles sont exposées par ladite fenêtre de lumière; et
une couche de protection transparente couvrant ladite seconde électrode, l'une desdites première et seconde électrodes bloquant la lumière tandis que l'autre laisse passer la lumière, des dessins étant formés dans lesdites première et seconde électrodes afin d'obtenir des signaux photogénérateurs entre elles.

3. Capteur selon la revendication 2, dans lequel ladite première électrode bloque la lumière et ladite seconde électrode est constituée par un film conducteur transparent s'étendant de façon à couvrir ladite fenêtre de lumière.

4. Capteur selon la revendication 2 ou la revendication 3, dans lequel ladite fenêtre de lumière est une ouverture ménagée à travers ladite première électrode et ledit film semi-conducteur.

5. Capteur selon la revendication 4, dans lequel ladite ouverture ménagée dans ladite première électrode est alignée avec ladite fenêtre de lumière.

6. Capteur selon la revendication 4, dans lequel la largeur de l'ouverture ménagée dans ladite première électrode et celle de la fenêtre de lumière sont égales.

7. Capteur selon la revendication 4, dans lequel la largeur de ladite ouverture ménagée dans ladite première électrode est supérieure à celle de ladite fenêtre de lumière.

8. Capteur selon la revendication 7, dans lequel l'ouverture ménagée dans ladite première électrode est formée de façon à ce que ladite première électrode et ladite seconde électrode ne soient pas en contact l'une avec l'autre au niveau de ladite fenêtre de lumière.

9. Capteur selon la revendication 7, dans lequel l'ouverture ménagée dans ladite première électrode est réalisée de façon à séparer électriquement ladite première électrode en deux parties, dont l'une est isolée de ladite seconde électrode et l'autre est en contact avec ladite seconde électrode au niveau de ladite ouverture.

10. Capteur d'image comprenant:
un substrat transparent;
un film conducteur bloquant la lumière, divisé en une multiplicité de premières électrodes par des rainures;
un film semi-conducteur de conversion photo-électrique formé sur ledit film conducteur bloquant la lumière;
des fenêtres de lumière s'ouvrant dans ledit film semi-conducteur et dans ledit film conducteur bloquant la lumière;
un film conducteur transparent divisé en une multiplicité de secondes électrodes par des rainures, lesdites secondes électrodes étant formées également dans lesdites fenêtres de lumière afin d'être en contact avec lesdites premières électrodes, si bien qu une multiplicité d'éléments de conversion photo-électrique sont formés entre des paires desdites premières et secondes électrodes qui sont en regard les unes des autres, ledit film semi-conducteur étant intercalé entre elles; et
une couche de protection transparente formée sur ledit film conducteur transparent.
